# EUROPEAN PATENT SPECIFICATION

(11) **EP 2 741 519 B1**
(45) Date of publication and mention of the grant of the patent: **11.05.2016**
(21) Application number: 13194983.6
(22) Date of filing: 29.11.2013
(51) Int. Cl.: H04Q 1/02, H05K 7/18

(54) **TELECOMMUNICATION EQUIPMENT**
TELEKOMMUNIKATIONSEINRICHTUNG
ÉQUIPEMENT DE TÉLÉCOMMUNICATIONS

(30) Priority: 04.12.2012 FI 20126264
(43) Date of publication of application: 11.06.2014
(73) Proprietor: Coriant Oy, 02630 Espoo (FI)
(72) Inventor: Kohonen, Petri, 01650 Vantaa (FI); Silvola, Mika, 90450 Kempele (FI); Sirola, Eero, 02360 Espoo (FI); Vallin, Päivi, 02330 Espoo (FI)
(74) Representative: Berggren Oy Ab

(56) References cited:
- US-A- 5 542 549
- US-A1- 2002 153 335
- US-A1- 2009 184 072

## Description

### Field of the invention

The invention relates to telecommunication equipment comprising one or more telecommunication devices and a rack for mechanically supporting the telecommunication devices.

### Background

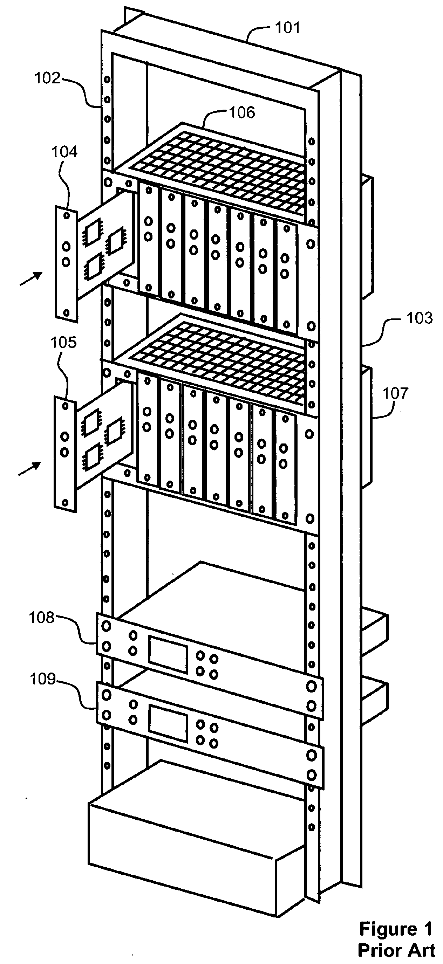

In many cases it is advantageous that telecommunication equipment is modular so that the equipment comprises a rack and telecommunication devices are installed in the rack. In this document the term "telecommunication" includes also "data communication" and other data and message transfer technologies. Each telecommunication device can be, for example but not necessarily, an internet protocol "IP" router, an Ethernet switch, an Asynchronous Transfer Mode "ATM" switch, and/or a MultiProtocol Label Switching "MPLS" switch. Figure 1 shows a perspective view of a commonly used construction of telecommunication equipment. A rack 101 of the telecommunication equipment comprises mutually parallel rails 102 and 103 that are substantially vertical when the rack is in its operating position. The telecommunication equipment comprises telecommunication devices which are plug-in units that are installed in plug-in unit slots of frames 106 and 107. Two of the plug-in units shown in figure 1 are denoted with reference numbers 104 and 105. The frames are attached to the rails 102 and 103 as illustrated in figure 1. The telecommunication equipment further comprises telecommunication devices 108 and 109 which are attached to the rails 102 and 103 as illustrated in figure 1. Typically, telecommunication devices such as the telecommunication devices 108 and 109 are called "pizza-box" devices. The telecommunication equipment shown in figure 1 is often enclosed with a cabinet and the telecommunication equipment is often provided with one or more fans for blowing cooling air. Neither the cabinet nor the fans are shown in figure 1.

The cooling of the plug-in units is straightforward to arrange with the aid of vertically directed cooling air flow because the frames 106 and 107 can be easily constructed so that the vertically directed cooling air flow can pass through them. In the exemplifying case illustrated in figure 1, the horizontal walls of the frames comprise grids for allowing the vertically directed cooling air flow. The pizza-box type telecommunication devices 108 and 109 are, however, more problematic because, as can be understood with the aid of figure 1, they significantly disturb the vertically directed cooling air flow in a cabinet of the telecommunication equipment.

Publication US5542549 describes a versatile rack for supporting telecommunication devices. The rack comprises first and second spaced and parallel members, each having a U-shape profile. The rack further comprises third and fourth spaced and parallel members, each having an L-shape profile. The first, second, third, and fourth member define a rectangle where the third member is transversely attached to the first and second members and the fourth member is transversely attached to the first and second members.

### Summary

The following presents a simplified summary in order to provide a basic understanding of some aspects of various invention embodiments. The summary is not an extensive overview of the invention. It is neither intended to identify key or critical elements of the invention nor to delineate the scope of the invention. The following summary merely presents some concepts of the invention in a simplified form as a prelude to a more detailed description of exemplifying embodiments of the invention.

In accordance with the invention, there is provided new telecommunication equipment that comprises:
- at least one telecommunication device having a width, a thickness, and a length, the thickness being smaller than the width and smaller than the length, and
- a rack comprising mutually parallel first rails that are substantially vertical when the rack is in its operating position.

The rack further comprises a second rail attached to the first rails and a third rail attached to the first rails, the third rail being parallel to the second rail and a distance apart from the second rail. The second and third rails are arranged to mechanically support the telecommunication device so that:
- the telecommunication device is in a first position with respect to the rack,
- the telecommunication device is attached to the second and third rails, and
- the thickness of the telecommunication device is in a direction substantially perpendicular to the first rails and the width of the telecommunication device is in a direction substantially parallel to the first rails.

The distance between the first rails is such that the first rails are suitable for mechanically supporting the telecommunication device so that:
- the telecommunication device is in a second position, different from the first position, with respect to the rack,
- the telecommunication device is attached to the first rails, and
- the thickness of the telecommunication device is in the direction substantially parallel to the first rails and the width of the telecommunication device is in the direction substantially perpendicular to the first rails.

In the above-described telecommunication equipment, the telecommunication device can be positioned so that its largest surfaces, i.e. the surfaces defined by the length and the width, are in upright position. Therefore, the one or more circuit boards of the above-mentioned telecommunication device can be positioned in upright position. This makes the cooling more effective than in conjunction with typical prior art equipment where the largest surfaces are in horizontal position.

A number of non-limiting exemplifying embodiments of the invention are described in accompanied dependent claims.

Various non-limiting exemplifying embodiments of the invention both as to constructions and to methods of operation, together with additional objects and advantages thereof, will be best understood from the following description of specific exemplifying embodiments when read in connection with the accompanying drawings.

The verbs "to comprise" and "to include" are used in this document as open limitations that neither exclude nor require the existence of unrecited features. The features recited in depending claims are mutually freely combinable unless otherwise explicitly stated.

### Brief description of the figures

The exemplifying embodiments of the invention and their advantages are explained in greater detail below in the sense of examples and with reference to the accompanying drawings, in which:
figure 1 shows a perspective view of telecommunication equipment according to the prior art, and
figure 2 shows a perspective view of telecommunication equipment according to an exemplifying embodiment of the invention.

Figure 1 has been explained already in the background section of this document.

### Description of the exemplifying embodiments

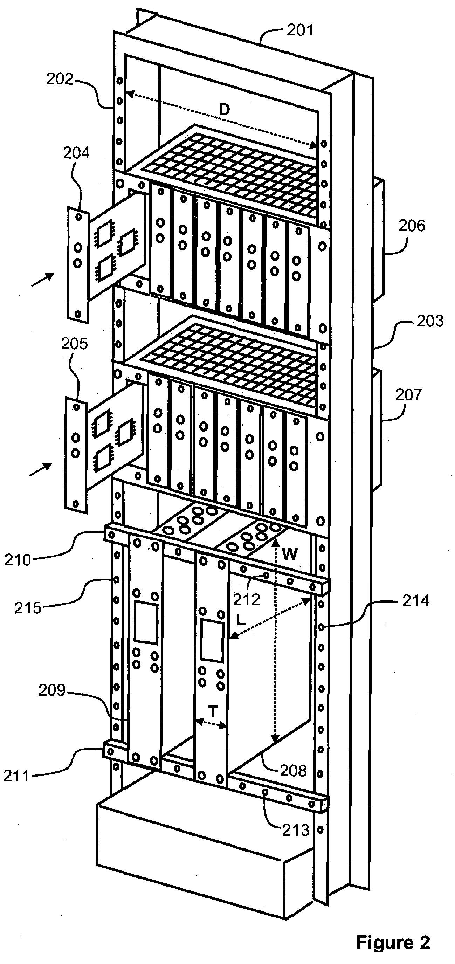

Figure 2 shows a perspective view of telecommunication equipment according to an exemplifying embodiment of the invention. The equipment comprises a rack 201 and telecommunication devices installed in the rack. Each telecommunication device can be, for example but not necessarily, an internet protocol "IP" router, an Ethernet switch, an Asynchronous Transfer Mode "ATM" switch, and/or a MultiProtocol Label Switching "MPLS" switch. The rack 201 comprises mutually parallel first rails 202 and 203 that are substantially vertical when the rack is in its operating position. Some of the telecommunication devices are plug-in units that are installed in plug-in unit slots of frames 206 and 207 which are attached to the first rails 202 and 203 as illustrated in figure 2. Two of the plug-in units shown in figure 2 are denoted with reference numbers 204 and 205. The frames are attached to the first rails 202 and 203 as illustrated in figure 2. Each of the frames 206 and 207 may comprise, for example, wirings such that the plug-in units installed in the frame form a full mesh network or such that a plug-in unit installed in the frame is connected to a central element which may comprise one or more other plug-in units installed in the frame or which may be a functional component integrally built in the frame. The wirings are typically located on the backplane of the frame. The telecommunication equipment shown in figure 2 is often enclosed with a cabinet and the telecommunication equipment is typically provided with one or more fans for blowing cooling air. Neither the cabinet nor the fans are shown in figure 2.

The rack 201 further comprises a second rail 210 attached to the first rails 202 and 203 and a third rail 211 attached to the first rails 202 and 203. The third rail 211 is parallel to the second rail 210 and a distance apart from the second rail as illustrated in figure 2. It is to be noted that the second and third rails 210 and 211 do not necessarily have to be separate pieces but there can be one or more vertical connecting parts between the second and third rails so that the second and third rails and the one or more vertical connecting parts constitute a single piece.

The telecommunication equipment further comprises telecommunication devices 208 and 209 each having a width, a thickness, and a length, where the thickness is smaller than the width and smaller than the length. The length can be equal to the width, smaller than the width, or greater than the width. The width, the thickness, and the length of the telecommunication device 208 are denoted in figure 2 with letters W, T, and L, respectively. The width W can be, for example but not necessarily, about 19 inches, the thickness T can be, for example but not necessarily, about 1.8 inches, and the length L can be, for example but not necessarily, about 12 inches.

The second and third rails 210 and 211 are arranged to mechanically support the telecommunication devices 208 and 209 so that these telecommunication devices are attached to the second and third rails 210 and 211 as illustrated in figure 2. The thicknesses of the telecommunication devices 208 and 209 are in the direction substantially perpendicular to the first rails 202 and 203 and the widths of these telecommunication devices are in the direction substantially parallel to the first rails. Therefore, the telecommunication devices 208 and 209 are vertically positioned so that their largest surfaces, i.e. the surfaces defined by the length and the width, are in upright position. This facilitates the cooling of the telecommunication equipment.

In telecommunication equipment according to an exemplifying embodiment of the invention, the distance D between the first rails 202 and 203 is such that the first rails are suitable for mechanically supporting the telecommunication devices 208 and 209 so that these telecommunication devices can be installed also in the same traditional way as the telecommunication devices 108 and 109 are installed in the telecommunication equipment shown in figure 1. In other words, the telecommunication devices 208 and 209 can be attached to the first rails 202 and 203 so that the thicknesses of these telecommunication devices are in the direction substantially parallel to the first rails and the widths of the telecommunication device are in the direction substantially perpendicular to the first rails.

In telecommunication equipment according to an exemplifying embodiment of the invention, the second and third rails 210 and 211 are provided with mounting holes and the distance from a mounting hole 212 of the second rail to a corresponding mounting hole 213 of the third rail is 19 inches, 21 inches, or 23 inches, or 435 mm, 450 mm, 465 mm, or 600 mm.

In telecommunication equipment according to an exemplifying embodiment of the invention, the first rails 202 and 203 are provided with mounting holes, and the distance from a mounting hole 214 of the first rail 203 to the corresponding mounting hole 215 of the first rail 202 is 19 inches, 21 inches, or 23 inches, or 435 mm, 450 mm, 465 mm, or 600 mm.

The specific examples provided in the description given above should not be construed as limiting the applicability and/or the interpretation of the appended claims.

## Claims

1. Telecommunication equipment comprising:
- at least one telecommunication device (208, 209) having a width, a thickness, and a length, the thickness being smaller than the width and smaller than the length, and
- a rack (201) comprising mutually parallel first rails (202, 203) that are substantially vertical when the rack is in its operating position,
wherein the rack further comprises a second rail (210) attached to the first rails and a third rail (211) attached to the first rails, the third rail being parallel to the second rail and a distance apart from the second rail, and the second and third rails are arranged to mechanically support the telecommunication device so that:
- the telecommunication device is in a first position with respect to the rack,
- the telecommunication device is attached to the second and third rails, and
- the thickness of the telecommunication device is in a direction substantially perpendicular to the first rails and the width of the telecommunication device is in a direction substantially parallel to the first rails,
**characterized in that** a distance between the first rails is such that the first rails are suitable for mechanically supporting the telecommunication device so that:
- the telecommunication device is in a second position, different from the first position, with respect to the rack, and
- the telecommunication device is attached to the first rails, and
- the thickness of the telecommunication device is in the direction substantially parallel to the first rails and the width of the telecommunication device is in the direction substantially perpendicular to the first rails.

2. Telecommunication equipment according to claim 1, wherein the second and third rails are provided with mounting holes and the distance from a mounting hole (212) of the second rail to a corresponding mounting hole (213) of the third rail is one of the following: 19 inches, 21 inches, 23 inches, 435 mm, 450 mm, 465 mm, or 600 mm.

3. Telecommunication equipment according to claim 1 or 2, wherein the first rails are provided with mounting holes, and the distance from a mounting hole (214) of one of these first rails to the corresponding mounting hole (215) of the other of these first rails is one of the following: 19 inches, 21 inches, 23 inches, 435 mm, 450 mm, 465 mm, or 600 mm.

4. Telecommunication equipment according to any of claims 1-3, wherein the at least one telecommunication device is at least one of the following: an internet protocol "IP" router, an Ethernet switch, an Asynchronous Transfer Mode "ATM" switch, a MultiProtocol Label Switching "MPLS" switch.

## Patentansprüche

1. Telekommunikationsausrüstung umfassend:
- mindestens eine Telekommunikationsvorrichtung (208, 209) mit einer Breite, einer Dicke und einer Länge, wobei die Dicke kleiner als die Breite und kleiner als die Länge ist, und
- ein Gestell (201), welches zueinander parallele erste Leisten (202, 203) umfasst, die im Wesentlichen vertikal sind, wenn das Gestell in seiner Betriebsposition ist,
wobei das Gestell ferner eine zweite Leiste (210), welche an den ersten Leisten angebracht ist, und eine dritte Leiste (211) umfasst, welche an den ersten Leisten angebracht ist, wobei die dritte Leiste zu der zweiten Leiste parallel ist und um einen Abstand von der zweiten Leiste beabstandet ist, und wobei die zweite und die dritte Leiste dazu eingerichtet sind, um die Telekommunikationsvorrichtung mechanisch zu haltern, so dass:
- die Telekommunikationsvorrichtung in einer ersten Position ist in Bezug auf das Gestell,
- die Telekommunikationsvorrichtung an der zweiten und der dritten Leiste angebracht ist und
- die Dicke der Telekommunikationsvorrichtung in einer zu den ersten Leisten im Wesentlichen rechtwinkligen Richtung ist und die Breite der Telekommunikationsvorrichtung in einer zu den ersten Leisten im Wesentlichen parallelen Richtung ist,
**dadurch gekennzeichnet, dass** ein Abstand zwischen den ersten Leisten derart ist, dass die ersten Leisten zum mechanischen Haltern der Telekommunikationsvorrichtung geeignet sind, so dass:
- die Telekommunikationsvorrichtung in einer sich von der ersten Position unterscheidenden zweiten Position ist in Bezug auf das Gestell, und
- die Telekommunikationsvorrichtung an den ersten Leisten angebracht ist und
- die Dicke der Telekommunikationsvorrichtung in der zu den ersten Leisten im Wesentlichen parallelen Richtung ist und die Breite der Telekommunikationsvorrichtung in der zu den ersten Leisten im Wesentlichen rechtwinkligen Richtung ist.

2. Telekommunikationsausrüstung nach Anspruch 1, wobei die zweite und die dritte Leiste mit Befestigungslöchern versehen sind und der Abstand von einem Befestigungsloch (212) der zweiten Leiste zu einem entsprechenden Befestigungsloch (213) der dritten Leiste einer der Folgenden ist: 19 Inch, 21 Inch, 23 Inch, 435 mm, 450 mm, 465 mm oder 600 mm.

3. Telekommunikationsausrüstung nach Anspruch 1 oder 2, wobei die ersten Leisten mit Befestigungslöchern versehen sind und der Abstand von einem Befestigungsloch (214) von einer dieser ersten Leisten zu dem entsprechenden Befestigungsloch (215) von der anderen dieser ersten Leisten einer der Folgenden ist: 19 Inch, 21 Inch, 23 Inch, 435 mm, 450 mm, 465 mm oder 600 mm.

4. Telekommunikationsausrüstung nach einem der Ansprüche 1 bis 3, wobei die mindestens eine Telekommunikationsvorrichtung mindestens eine der Folgenden ist: ein Internet Protokoll "IP" Router, ein Ethernet Switch, ein Asynchronous Transfer Mode "ATM" Switch, ein MultiProtokoll Label Switching "MPLS" Switch.

## Revendications

1. Equipement de télécommunications comportant :
- au moins un dispositif de télécommunications (208, 209) présentant une largeur, une épaisseur et une longueur, l'épaisseur étant plus petite que la largeur et plus petite que la longueur, et
- une baie (201) comprenant des premiers rails, mutuellement parallèles, (202, 203), lesquels sont essentiellement verticaux lorsque la baie se trouve dans sa position fonctionnelle,
dans lequel la baie comporte, de plus, un deuxième rail (210) fixé aux premiers rails et un troisième rail (211) fixé aux premiers rails, le troisième rail étant parallèle au deuxième rail et séparé d'une certaine distance du deuxième rail, et les deuxième et troisième rails sont agencés de façon à supporter mécaniquement le dispositif de télécommunications de sorte que :
- le dispositif de télécommunication se trouve dans une première position par rapport à la baie,
- le dispositif de télécommunications est fixé aux deuxième et troisième rails, et
- l'épaisseur du dispositif de télécommunications se présente dans une direction essentiellement perpendiculaire aux premiers rails et la largeur du dispositif de télécommunications se présente dans une direction essentiellement parallèle aux premiers rails, **caractérisé en ce que** la distance entre les premiers rails est telle que les premiers rails sont appropriés pour supporter mécaniquement le dispositif de télécommunications, de sorte que :
- le dispositif de télécommunications se présente dans une seconde position, différente de la première position par rapport à la baie, et
- le dispositif de télécommunication est fixé aux premiers rails, et
- l'épaisseur du dispositif de télécommunications se présente dans la direction essentiellement parallèle aux premiers rails et la largeur du dispositif de télécommunications se présente dans la direction essentiellement perpendiculaire aux premiers rails.

2. Equipement de télécommunications selon la revendication 1, dans lequel les deuxième et troisième rails sont pourvus de trous de montage et dans lequel la distance depuis un trou de montage (212) du deuxième rail à un trou de montage correspondant (213) du troisième rail est l'une des distances suivantes : 19 pouces, 21 pouces, 23 pouces, 435 mm, 450 mm, 465 mm ou 600 mm.

3. Equipement de télécommunications selon la revendication 1 ou 2, dans lequel les premiers rails sont pourvus de trous de montage, et la distance depuis un trou de montage (214) de l'un de ces premiers rails jusqu'au trou de montage correspondant (215) de l'autre de ces premiers rails est l'une des distance suivante : 19 pouces, 21 pouces, 23 pouces, 435 mm, 450 mm, 465 mm, ou 600 mm.

4. Equipement de télécommunications selon l'une quelconque des revendications 1 à 3, dans lequel au moins un dispositif de télécommunications est au moins l'un des dispositifs suivants : un routeur « IP » de protocole internet, un commutateur Ethernet, un commutateur en « ATM » (Mode de Transfert Asynchrone), un commutateur « MPLS » (Commutation par Etiquettes Multi-Protocoles).
